# EUROPEAN PATENT SPECIFICATION

(11) **EP 4 293 907 B1**
(45) Date of publication and mention of the grant of the patent: **28.10.2026**
(21) Application number: 23164910.4
(22) Date of filing: 29.03.2023
(51) Int. Cl.: H03K 3/03, H03K 5/156

(54) **CLOCK GENERATOR CIRCUIT, CORRESPONDING DEVICE AND METHOD**
TAKTGENERATORSCHALTUNG, ENTSPRECHENDE VORRICHTUNG UND VERFAHREN
CIRCUIT GÉNÉRATEUR D'HORLOGE, DISPOSITIF ET PROCÉDÉ CORRESPONDANTS

(30) Priority: 16.06.2022 IT 202200012767
(43) Date of publication of application: 20.12.2023
(73) Proprietor: STMicroelectronics S.r.l., 20864 Agrate Brianza (MB) (IT)
(72) Inventor: VINCENZONI, David, 20862 Arcore (Monza Brianza) (IT)
(74) Representative: Buzzi, Notaro & Antonielli d'Oulx S.p.A.

(56) References cited:
- US-A1- 2007 001 771
- US-A1- 2010 156 468
- US-B1- 7 675 332

## Description

### Technical field

The description relates to clock generators.

One or more embodiments can be advantageously applied in a variety of arrangements.

Clock recovery circuits where data are transmitted over a channel without transmitting a clock signal together with the data are exemplary of an area where embodiments can be applied advantageously.

### Description of the related art

In digital clock generation, in particular with a ring oscillator, local oscillators that are simple, low-power and low-cost are highly desirable, even if with a moderate precision.

Such oscillators can be implemented using delay elements (delay lines or stages) providing delay-lock-loop (DLL) cells: each delay cell introduces a delay which can be used for the generation of the clock.

Oscillators based on the DLL concept are exposed to the risk that oscillation is undesirably discontinued after a while, due to slightly different delay times for the individual delay cells.

These are mainly due to different delays between rise and fall times, with this behavior leading to a distortion of pulses: the pulses can disappear after a while or can settle to a constant value (e.g., "1").

Stated otherwise, due to different delays introduced by the individual DLL cells for rising and falling signals, the delayed signal becomes distorted and after a while its width decrease to zero (assuming, e.g., Trise > Tfall). This may lead to undesired switch-off of the clock signal.

More specifically, the invention relates to a circuit according to the preamble of claim 1, which is known, for instance, from US 2007/001771 A1. Document US 2020/156468 A1 is also of interest for the invention.

### Object and summary

An object of one or more embodiments is to contribute in addressing the issues discussed above.

According to one or more embodiments, that object is achieved via a circuit having the features set forth in claim 1 that follows.

One or more embodiments relate to a corresponding device as per claim 11. A clock recovery circuit for use, e.g., in a receiver for use in automated toll payment may be exemplary of such a device.

One or more embodiments relate to a corresponding method as per claim 12.

The claims are an integral part of the technical teaching provided herein in respect of the embodiments.

In a circuit as exemplified herein, the feedback signal for the DLL loop is generated via a flip-flop that is set and reset by pulses generated by DLL cells arranged at the end and in the middle of delay line.

In a circuit as exemplified herein, a clock signal can be generated by a flip-flop that is controlled based on the signal at the end of the chain which sets the flip flop and is reset by a stage located at an intermediate (about halfway, for instance) position of the DLL chain for which the duration of the pulse, namely Tpulse, is more than the delay Td applied by the individual delay cells and less than N*Td, where N is the number of the cells in the DLL delay line.

In a circuit as exemplified herein, clock pulses (clock signal CLK) are generated in a continued manner as long as an enable is asserted. For a stage located at an intermediate (about halfway, for instance) position of the DLL chain the relationships Tpulse < N*Td and Tpulse > Td will apply.

In a circuit as exemplified herein, the period of the clock signal generated is 2*Td, with a signal feed_sig fed to the DLL generator having a stable width as a result of being produced as a function of "set" and "clear" pulse signals clk_set and clk_clr.

A circuit as exemplified herein facilitates generating a clock signal as long as an enable pin is set using a simple arrangement with (very) low power consumption: the clock signal can be activated only in response to a start pulse being set.

A circuit as exemplified herein lends itself to being calibrated, e.g., in order to compensate PVT-induced (PVT = Process, Voltage, Temperature) variations to facilitate obtaining a precise clock

### Brief description of the figures

One or more embodiments will now be described, by way of example only, with reference to the annexed figures, wherein:
Figure 1A is generally illustrative of the possibility of using delay lines to provide a clock generator,
Figure 1B comprises various diagrams exemplary of signals which may occur in such a delay line,
Figure 2 is a circuit diagram of a clock generator circuit, not covered by the invention, including a plurality of delay lines,
Figure 3 is a circuit diagram of the clock generator circuit of Figure 2 including embodiments of the present description,
Figure 4 comprises various diagrams exemplary of the possible time behavior of signals which may occur in a clock generator circuit according to embodiments of the present description, and
Figures 5 and 6 illustrate possible details of implementing a clock generator circuit according to embodiments of the present description.

The figures are drawn to clearly illustrate the relevant aspects of the embodiments and are not necessarily drawn to scale.

The edges of features drawn in the figures do not necessarily indicate the termination of the extent of the feature.

Corresponding numerals and symbols in the different figures generally refer to corresponding parts unless otherwise indicated.

Also, throughout this description, a same designation may be used for brevity to designate:
a certain node or line as well as a signal occurring at that node or line, and
a certain component as well as an electrical parameter thereof (e.g., the delay provided by a delay element or line).

### Detailed description

In the ensuing description, various specific details are illustrated in order to provide an in-depth understanding of various examples of embodiments according to the description. The embodiments may be obtained without one or more of the specific details, or with other methods, components, materials, etc. In other cases, known structures, materials, or operations are not illustrated or described in detail so that various aspects of the embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment", "in one embodiment", or the like, that may be present in various points of the present description do not necessarily refer exactly to one and the same embodiment. Furthermore, particular configurations, structures, or characteristics may be combined in any adequate way in one or more embodiments.

The headings/references used herein are provided merely for convenience and hence do not define the extent of protection or the scope of the embodiments.

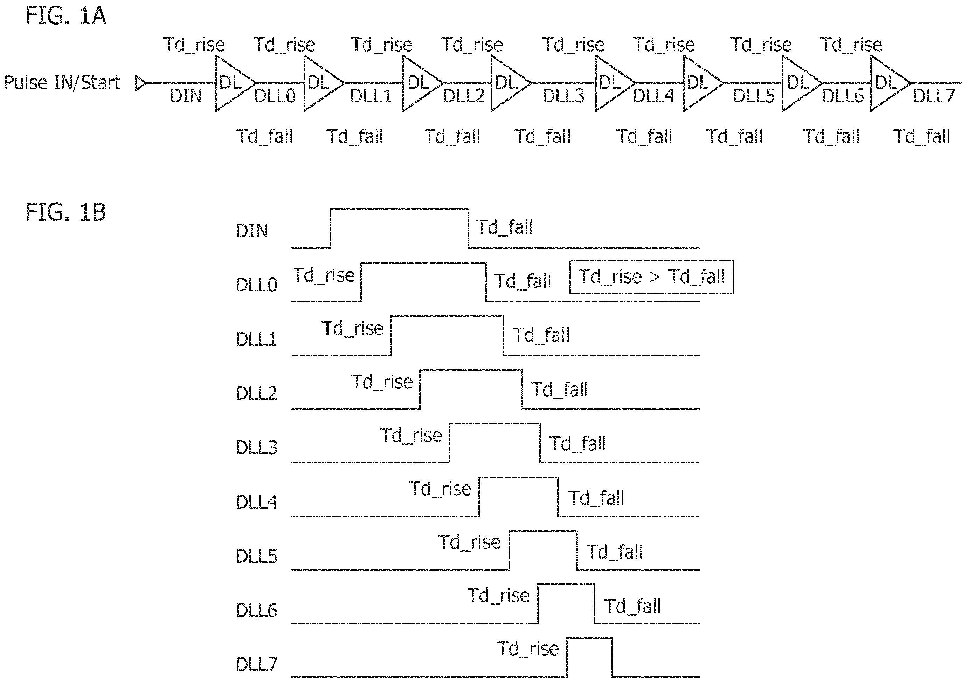

Figure 1A is generally illustrative of the possibility of using a chain of cascaded delay cells (delay stages or elements) DL to provide a clock generator based on a Pulse IN/Start signal supplied as a (pulsed) signal DIN to the first delay cell in the chain.

As illustrated in the diagrams of Figure 1B, the cells DL in the chain operate with respective rise and fall times Td_rise and Td_fall in producing correspondingly delayed signals DLL0, DLL1, DLL2, DLL3, DLL4, DLL5, DLL6, DLL7. The number N of the cells in the chain (here N=8) is of course merely exemplary.

In order to provide a clock generator, delay cells DL in a chain as illustrated in Figure 1A are closed in a loop (oftentimes referred to as a delay-lock loop or DLL).

In certain cases, one may observe that operation of such a clock generator may be discontinued after a while.

Even without wishing to be bound to any specific theory in that respect, this phenomenon can be related to the (slightly) different delay times actually provided by each individual delay cell, mainly due to different rise and fall times Td_rise and Td_fall.

By referring to the diagrams of Figure 1B, if, e.g., Td_rise > Td_fall, each delay cell DL will take longer in switching from "0" to "1" (rising) than in switching back from "1" to "0" (falling). As a result, in addition to being increasing delayed with respect to the signal DIN input to the first delay cell in the chain, the signals DLL0, DLL1, DLL2, DLL3, DLL4, DLL5, DLL6, DLL7 will have an increasingly shorter pulse duration.

Especially in the case of "long" delay chains (N>>1), the pulses expected to propagate along the delay arrangement may disappear after a while or can become set to a fixed value (e.g., "1").

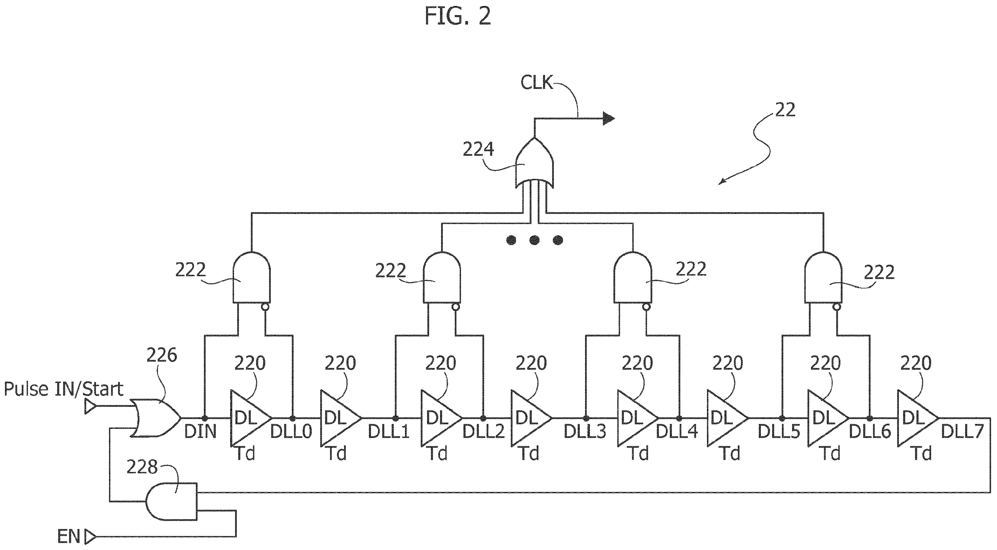

Figure 2 is a circuit diagram of a (local) oscillator 22 implemented as a delay-locked-loop (DLL) circuit, not covered by the invention, configured to generate a clock signal CLK. The frequency of the generated clock is a function of the delay implemented.

In the implementation illustrated in Figure 2 (as disclosed in EP 4 175 215 A1- David Vincenzoni, inventor, assigned to the same assignee of the present application and not yet available to the public at the time the present application is filed) the delay-locked-loop (DLL) circuit 22 can be implemented as a chain of cascaded delay units 220 configured to apply a respective delay time Td (e.g., 16ns to 32ns: of course, these values are merely exemplary and non-limiting).

A combinatorial logic coupled to the delay units 220 generates a clock signal CLK having a (semi)period that is a function of the delay Td.

As illustrated, the combinatorial logic comprises AND gates 222 coupled to every other delay unit 220 starting from the first to the next-to-last delay unit 220 in the chain (cascade). Each to the AND gates 222 has a first input coupled to the input (DIN, DLL1, DLL3, DLL5, and so on) of an associated delay unit 220 and a second negated input coupled to the output (DLL0, DLL2, DLL4, DLL6, and so on) of the associated delay unit 220.

The outputs of the AND gates 222 are supplied as inputs to an OR gate 224 that produces a clock signal CLK as an output.

That is, the gates 222, 224 provide logic circuitry configured to generate the local clock signal CLK as a function of input signals applied to the delay units 220 in the chain.

As illustrated in Figure 2, such logic circuitry thus comprises a set of AND gates 222 coupled to alternate ones of the delay units 220 in the chain, wherein each AND gate in the set has a first input coupled to the input (e.g., DIN, DLL1, DLL3, DLL5) of a respective delay unit 220 coupled thereto and a second input coupled to the (inverted) input (e.g., DLL0, DLL2, DLL4, DLL6) to the delay unit following the respective delay unit 220 in the chain.

The OR gate 224 coupled to the outputs of the AND gates thus produces the local clock signal CLK.

In the arrangement illustrated in Figure 2, an OR gate 226 at the input of the DLL circuit 22 receives:
as a first input, a Pulse IN/Start signal, and
as a second input, the output from an AND gate 228 in turn receiving as inputs the output (here, DLL7) of the last delay unit 220 in the chain/cascade of delay units and an enable signal EN provided in a manner known per se, e.g., via a simple finite state machine (FSM) or a rough data detector (not visible in the figure).

The output from the OR gate 226 at the input of the DLL circuit 22 is applied as the input DIN to the first delay unit 220 in the chain/cascade of delay units.

In the arrangement illustrated in Figure 2, the Pulse IN/Start signal is a pulse signal having a (notional) "on" time Tpulse and a period between Td (the delay time of the delay units 220) and M*Td, where M is the number of delay units 22 in the chain/cascade of delay units in the DLL circuit.

That is: Tpulse < M*Td AND Tpulse > Td.

For instance, in the example illustrated, M = 8 (eight).

The signal Pulse IN/Start can be generated from a Start signal (generated in any manner known to those of skill in the art) via logic circuitry (not visible in Figure 2) associated with the DLL oscillator 22.

As long as the enable signal EN is active, the clock pulses (signal CLK) are generated continuously with a clock period 2*Td, where Td is the delay time of the delay units 220.

It was noted that, in certain cases, the risk of having an undesirably short pulse at the end of the chain may militate against proper desired operation of a DLL oscillator 22 as illustrated in Figure 2. In fact, due to a different delay introduced by the cells 220 for rising and falling signal, the delayed signal becomes distorted with its width decreasing towards to zero (assuming Trise > Tfall): see, e.g., the diagrams of Figure 1B. This may even lead to an undesired clock switch-off.

The diagrams of Figure 1B indicate that pulse "narrowing" (that is, the reduction of the time the pulses DLL0 to DLL7 are "on") increases with the number of the delay cells traversed by the signal. One might thus consider addressing the problem mentioned above by adding an inverter halfway the delay line so that, downstream of the inverter, gradual pulse narrowing would be compensated.

It is noted that this will lead an undesired instability of the oscillation, with the risk that the clock signal CLK may end up by being "stuck" at 0 or 1.

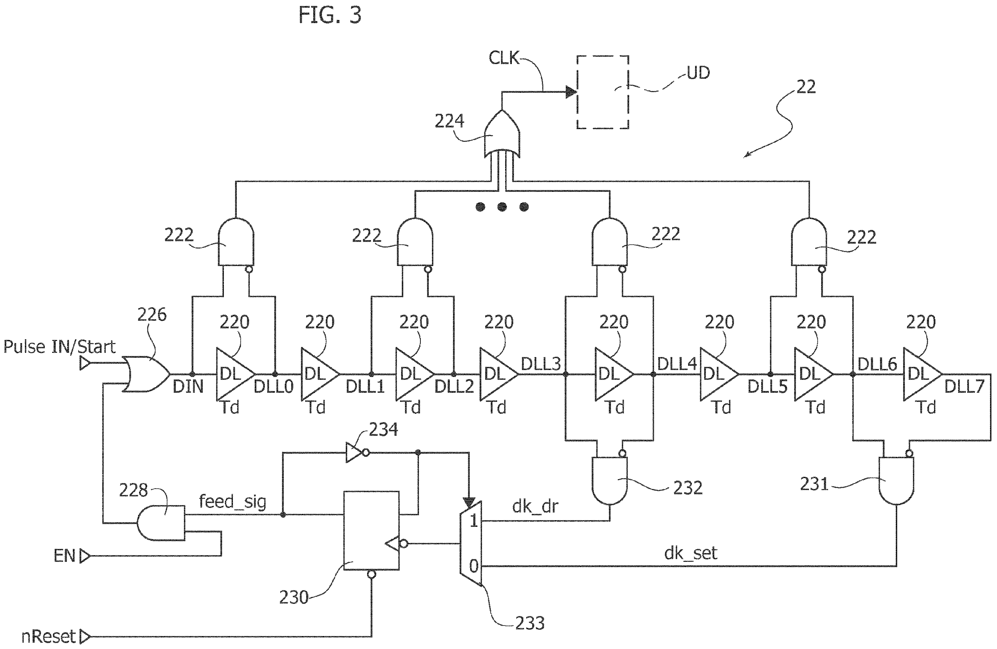

In the example presented in Figure 3 (where parts or elements like parts or elements already described in connection with the preceding figures are indicated with like references numbers/symbols so that a corresponding description will not be repeated for brevity) the feedback signal feed_sig fed back to the input of the delay chain (OR gate 226) - e.g., via the AND gate 228 for gating by the enable signal EN - is not derived (exclusively) from the end of the chain (output of the last delay cell 220 in the cascade of delay cells).

Like in the case of Figure 2, in the example presented in Figure 3 the clock signal CLK (that is adapted to be supplied to a user device UD of any known type, usually a distinct element from the circuit 10) is produced via logic circuitry comprising a set of AND gates 222 coupled to alternate ones of the delay units 220 in the delay unit chain.

As illustrated, each AND gate in the set has a first input coupled to the input (DIN, DLL1, DLL3, DLL5) of a respective delay unit 220 coupled thereto and a second input receiving the - logically inverted - input DLL0, DLL2, DLL4, DLL6 of the delay unit following the respective delay unit 220 in the chain. An OR gate 224 coupled to the outputs of the AND gates 222 produces the clock signal CLK.

It is otherwise noted that the logic circuitry 222, 224 used to produce the clock signal CLK is merely exemplary of one of a plurality of options that can be resorted to by those of skill in the art for that purpose: the embodiments herein are in fact primarily concerned with the feedback network used to counter undesired switch-off of the DLL loop.

In the example presented in Figure 3, the feedback signal feed_sig is sourced:
at the end of the chain (output of the last delay cell 220 in the cascade of delay cells), and
at (at least) one cell in an intermediate position in the chain.

In the example illustrated in Figure 3, the cell involved is the fifth cell in the chain (input DLL3 from the fourth cell - output DLL4 to the sixth cell), placed at an intermediate position that is approximately halfway the chain: in the example illustrated in Figure 3 the chain comprises 8 (eight) cells and 5 (five) is the nearest upper integer to 8/2 = 4.

In the example illustrated in Figure 3, the feedback signal feed_sig is generated by a flip-flop 230 that is clocked by pulses generated at the end and intermediate the delay chain.

In the example illustrated in Figure 3, a first logical signal clk_set is produced by a first AND gate 231 that receives:
as a first input, the signal DLL6 input to the last (here 8^{th}) delay cell 220 in the chain, and
as a second input the (logically inverted) signal DLL7 output from the last delay cell 220 in the chain.

Also, in the example illustrated in Figure 3, a second logical signal clk_clr is produced by a second AND gate 232 that receives:
as a first input, the signal DLL3 input to an intermediate (here 5^{th}) delay cell 220 in the chain, and
as a second input the (logically inverted) signal DLL4 output from the 5^{th} cell 220 in the chain.

The signals clk_set and clk_clr are fed to the inputs of a multiplexer 233 that applies alternately the signals clk_set and clk_clr to the flip-flop 230 in response to the output signal from an inverter 234 whose input is coupled to the output of the flip-flop 230, namely the feedback signal feed_sig.

As illustrated, the flip-flop 230 can be reset via a signal nReset (produced in a manner known per se to those of skilli in the art).

The example illustrated in Figure 3 effectively counters the risk of having (too) short pulses at the end of the delay chain.

The role of the negated inputs to the gates 231, 232 (and also to the gates 222) in forming the signals clk_set, clk_clr (and CLK) can be notionally equated to an inverter cell placed in the delay chain to act, e.g., on the signal DLL3: that is, such an inverter is "swapped" to other inputs. The feedback circuitry 226, 228, 230, 231, 232, 233 discussed herein thus includes inversion logic in the first feedback signal path (negated input to the gate 231) and in the second feedback signal path (negated input to the gate 232).

To summarize:
the feedback circuitry (namely 226, 228, 230, 231, 232, 233) configured to supply to the first delay unit in the chain of delay units 220 the feedback signal feed_sig, comprises:
i) a first feedback signal path (through the elements 226, 228, 230, 231, 233) from the last delay unit in the chain to the first delay unit in the chain, and
ii) a second feedback signal path (through the elements 226, 228, 230, 232, 233) from an intermediate delay unit in the chain to the first delay unit in the chain.

The intermediate delay unit is arranged between the first delay unit in the chain and the last delay unit, optionally at least approximately halfway between the first delay unit in the chain and the last delay unit in the chain: an arrangement as illustrated in Figure 3 comprises N (N = 8, for instance) delay units and the intermediate delay unit arranged in a position in the chain counted from the first delay unit which is a nearest integer of N/2.

For instance, with N = 8, the intermediate delay unit is the 5^{th} in the chain, with 5 being the nearest (upper) integer of N/2=4.

As illustrated in Figure 3, the first feedback signal path (through the elements 226, 228, 230, 231, 233) and the second feedback signal path (through the elements 226, 228, 230, 232, 233) comprise a first feedback branch (e.g., the AND gate 231) coupled to the last delay unit in the chain as well as a second feedback branch (e.g., the AND gate 232) coupled to the intermediate delay unit in the chain.

A common feedback branch through the elements 226, 228, 230, 233 comprise the multiplexer 233 that is coupled to the first feedback branch 231 and to the second feedback branch 232.

The multiplexer 233 is configured to supply to the first delay unit in the chain (here, via the gates 228 and 226) a feedback signal feed_sig based on, alternately:
a first feedback signal component, namely clk_set, received from the last delay unit in the chain via the first feedback branch (AND gate 231), or
a second feedback signal component, namely clk_clr, received from the intermediate delay unit in the chain via the second feedback branch (AND gate 232).

As illustrated, the first AND gate 231 (namely the first feedback branch) and the second AND gate 232 (namely the second feedback branch) receive as a first input and as a second, negated input, respectively:
the input signal DIN as propagated to the input and to the output the last delay unit in the chain,
the input signal DIN propagated to the input and to the output of the intermediate delay unit in the chain.

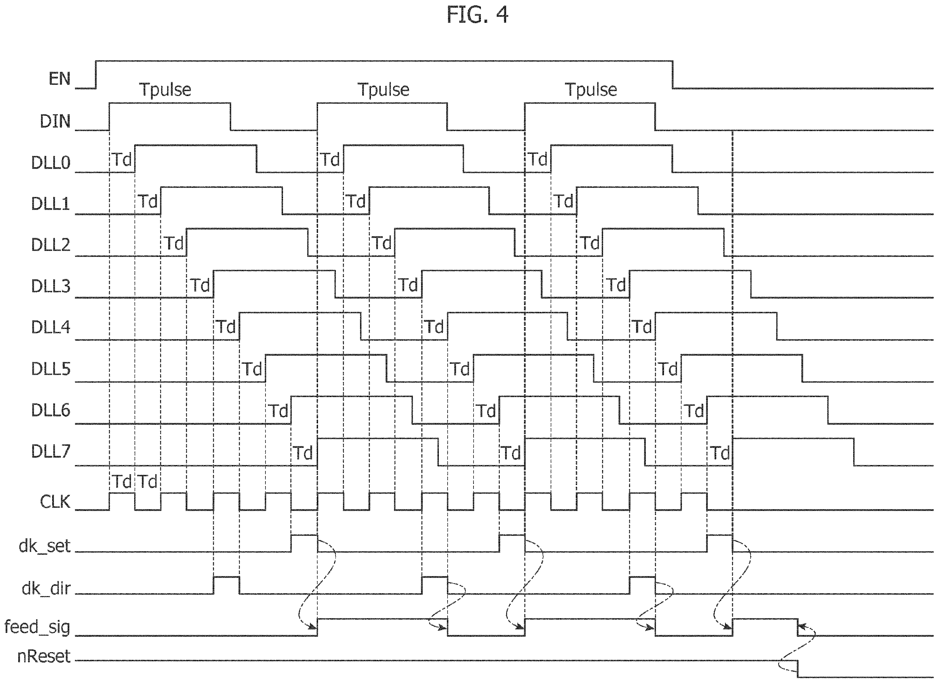

Figure 4 comprises various time diagrams sharing a common time (abscissa) scale that are exemplary of possible time behaviors of the following signals (from top to bottom):
the enable signal EN,
the signals, e.g., DIN, DLL0, DLL1, ..., DLL7 at the inputs/outputs of the delay units 220,
the clock signal CLK (having a period 2 x Td),
the signal clk_set,
the signal clk_clr,
the signal feed_sig, and
the signal nReset.

As illustrated in Figure 4, as long as the enable signal EN is active, the clock pulses (CLK) are generated in continuous way with a clock period given by 2*Td.

The feedback signal feed_sig is generated starting from the signals (pulses) clk_set and clk_clr collected both at the end (clk_set) and at an intermediate position (approximately halfway) the delay line (clk_clr), thus facilitating. keeping the width of feed_sig stable.

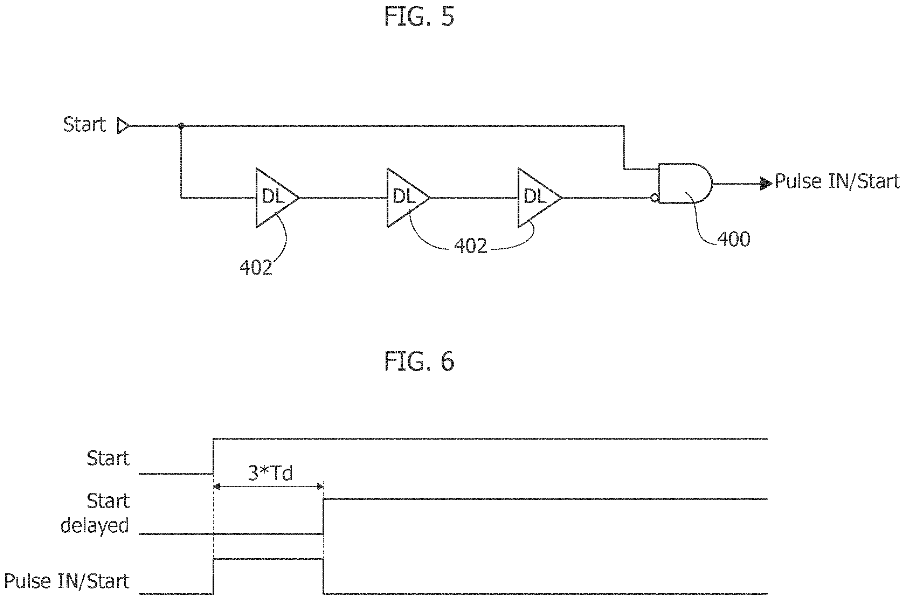

Figure 5 is exemplary of a circuit that can be advantageously used to produce the signal Pulse IN/Start from a (general) start signal Start.

As exemplified in Figure 5 the signal Start is "bifurcated" over a first path and a second path to the first input and a second input of AND gate 400.

The first path is a direct path over which the signal Start is applied directly to the first input of the AND gate 400.

The second path is a path through a set of (e.g., three) delay cells 402 and the signal Start thus delayed is applied to the second input of the AND gate 400 with logical inversion.

Figure 6 comprises various time diagrams sharing a common time (abscissa) scale that are exemplary of possible time behaviors of (from top to bottom): the Start signal, the Start signal delayed by the cells 402 and the resulting signal Pulse IN/Start. It is noted that selecting the input-to-output delay time of the cells 402 equal to the input-to-output delay time Td of the delay units 220 results in the pulsed start signal PulseIN/Start having a duration ("on" time) that is a multiple (e.g., three times) of the input-to-output delay time Td of the delay units 220.

The circuit as per the example illustrated in Figure 3 is simple and facilitates generating a clock signal in a continuous manner as long as an enable pin is set

It is fully digital and has a (very) low power consumption: the clock signal CLK can be activated only if the start pulse is set. The circuit lends itself to be calibrated, e.g., in order to compensate process, voltage, temperature (PVT) variations thus facilitating achieving an increased clock accuracy.

Without prejudice to the underlying principles, the details and the embodiments may vary, even significantly, with respect to what has been described by way of example only without departing from the scope of the invention.

The extent of protection is determined by the annexed claims.

## Claims

1. A circuit (10), comprising:
a cascaded arrangement of delay units (220) in a chain, each delay unit (220) having an input-to-output delay time (Td), wherein the first delay unit (220) in the chain is configured to receive an input signal (DIN) that is propagated along the delay units (220) in the chain,
logic circuitry (222, 224) coupled to delay units (220) in the chain, the logic circuitry (222, 224) configured to generate a clock signal (CLK) as a logic combination of signals input to and output from delay units (220) in the chain, and
feedback circuitry (226, 228, 230, 231, 232, 233) configured to supply to the first delay unit (220) in the chain a feedback signal (feed_sig), the feedback circuitry (228, 230, 231, 232, 233) comprising:
a first feedback signal path (226, 228, 230, 231, 233) from the last delay unit (220) in the chain to the first delay unit (220) in the chain, and
a second feedback signal path (226, 228, 230, 232, 233) from an intermediate delay unit (220) in the chain to the first delay unit (220) in the chain, the intermediate delay unit (220) in the chain arranged between the first delay unit (220) in the chain and the last delay unit (220) in the chain,
**characterized in that** the first feedback signal path (226, 228, 230, 231, 233) and the second feedback signal path (226, 228, 230, 232, 233) comprise:
a first feedback branch (231) coupled to the last delay unit (220) in the chain,
a second feedback branch (232) coupled to the intermediate delay unit (220) in the chain,
a common feedback branch (226, 228, 230, 233) comprising a multiplexer (233) coupled to the first feedback branch (231) and to the second feedback branch (232), the multiplexer (233) configured to supply to the first delay unit (220) in the chain a feedback signal (feed_sig) based on, alternately:
a first feedback signal component (clk_set) received from the last delay unit (220) in the chain via the first feedback branch (231), or
a second feedback signal component (clk_clr) received from the intermediate delay unit (220) in the chain via the second feedback branch (232).

2. The circuit (10) of claim 1, wherein the intermediate delay unit (220) in the chain is arranged at least approximately halfway between the first delay unit (220) in the chain and the last delay unit (220) in the chain.

3. The circuit (10) of claim 2, comprising a cascaded arrangement of N delay units (220) in said chain, wherein said intermediate delay unit (220) is arranged in a position in the chain counted from the first delay unit (220) which is a nearest integer of N/2.

4. The circuit (10) of any of the previous claims, wherein the feedback circuitry (226, 228, 230, 231, 232, 233) includes inversion logic in the first feedback signal path (231) and in the second feedback signal path (232).

5. The circuit (10) of claim 1, wherein:
the first feedback branch comprises a first AND gate (231) receiving as a first input and as a second, negated input said input signal (DIN) propagated to the input and to the output the last delay unit (220) in the chain,
the second feedback branch comprises a second AND gate (231) receiving as a first input and as a second, negated input said input signal (DIN) propagated to the input and to the output of the intermediate delay unit (220) in the chain.

6. The circuit (10) of claim 1 or claim 5, wherein the common feedback branch (228, 230, 233) comprises a flip-flop (230) driven by the multiplexer (233) and configured to produce said feedback signal (feed_sig) in response to being clocked, alternately, by the first feedback signal component (clk_set) received from the last delay unit (220) in the chain via the first feedback branch (231) and by the second feedback signal component (clk_clr) received from the intermediate delay unit (220) in the chain via the second feedback branch (232).

7. The circuit (10) of claim 6, wherein the flip-flop (230) receives as an input said feedback signal (feed_sig) after logic inversion (234).

8. The circuit (10) of any of the previous claims, wherein the feedback circuitry (226, 228, 230, 231, 232, 233) comprises an enable gate (228) configured to facilitate and counter, respectively, forwarding the feedback signal (feed_sig) to the first delay unit (220) in the chain based on an enable signal (EN).

9. The circuit (10) of any of the previous claims, comprising an input gate (266) configured to produce the input signal (DIN) propagated along the delay units (220) in the chain as the logic sum of said feedback signal (feed_sig) with a pulsed start signal (PulseIN/Start), the pulsed start signal (PulseIN/Start) preferably having a duration that is a multiple of the input-to-output delay time (Td) of the delay units in said cascaded arrangement of delay units (220).

10. The circuit (10) of any of the previous claims, wherein the logic circuitry comprises:
a set of AND gates (222) coupled to alternate ones of the delay units (220) in said chain, wherein each AND gate in the set has a first input coupled to the input (DIN, DLL1, DLL3, DLL5) of a respective delay unit (220) coupled thereto and a second input coupled to the inverted input (DLL0, DLL2, DLL4, DLL6) of the delay unit following the respective delay unit (220) in the chain, and
an OR gate (224) coupled to the outputs of the AND gates in said a set of AND gates (222), the OR gate (224) producing said clock signal (CLK).

11. A device, comprising:
a circuit (10) according to any of the previous claims, and
a user device (UD) coupled to said logic circuitry (222, 224) in the circuit to receive said clock signal (CLK) therefrom.

12. A method, comprising:
arranging in a chain of cascaded units a plurality of delay units (220) each having an input-to-output delay time (Td) and supplying to the first delay unit (220) in the chain an input signal (DIN) that is propagated along the delay units (220) in the chain,
generating a clock signal (CLK) as a logic combination of signals input to and output from delay units (220) in the chain, and
forwarding to the first delay unit (220) in the chain a feedback signal (feed_sig) via:
a first feedback signal path (226, 228, 230, 231, 233) from the last delay unit (220) in the chain to the first delay unit (220) in the chain, and
a second feedback signal path (226, 228, 230, 232, 233) from an intermediate delay unit (220) in the chain to the first delay unit (220) in the chain, the intermediate delay unit (220) in the chain arranged between the first delay unit (220) in the chain and the last delay unit (220) in the chain,
**characterized in that** the first feedback signal path (226, 228, 230, 231, 233) and the second feedback signal path (226, 228, 230, 232, 233) comprise:
a first feedback branch (231) coupled to the last delay unit (220) in the chain,
a second feedback branch (232) coupled to the intermediate delay unit (220) in the chain,
a common feedback branch (226, 228, 230, 233) comprising a multiplexer (233) coupled to the first feedback branch (231) and to the second feedback branch (232), the multiplexer (233) configured to supply to the first delay unit (220) in the chain a feedback signal (feed_sig) based on, alternately:
a first feedback signal component (clk_set) received from the last delay unit (220) in the chain via the first feedback branch (231), or
a second feedback signal component (clk_clr) received from the intermediate delay unit (220) in the chain via the second feedback branch (232).

## Patentansprüche

1. Schaltung (10), umfassend:
eine kaskadierte Anordnung von Verzögerungseinheiten (220) in einer Kette, wobei jede Verzögerungseinheit (220) eine Eingangs-zu-Ausgangs-Verzögerungszeit (Td) aufweist, wobei die erste Verzögerungseinheit (220) in der Kette so konfiguriert ist, dass sie ein Eingangssignal (DIN) empfängt, das entlang der Verzögerungseinheiten (220) in der Kette weitergeleitet wird,
Logikschaltkreise (222, 224), die mit Verzögerungseinheiten (220) in der Kette gekoppelt sind, wobei die Logikschaltkreise (222, 224) so konfiguriert sind, dass sie ein Taktsignal (CLK) als logische Kombination von Signalen erzeugen, die in die Verzögerungseinheiten (220) in der Kette eingegeben und von diesen ausgeben werden, und
Rückkopplungsschaltkreise (226, 228, 230, 231, 232, 233), die so konfiguriert sind, dass sie der ersten Verzögerungseinheit (220) in der Kette ein Rückkopplungssignal (feed_sig) liefern, wobei die Rückkopplungsschaltkreise (228, 230, 231, 232, 233) Folgendes umfassen:
einen ersten Rückkopplungssignalpfad (226, 228, 230, 231, 233) von der letzten Verzögerungseinheit (220) in der Kette zur ersten Verzögerungseinheit (220) in der Kette, und
einen zweiten Rückkopplungssignalpfad (226, 228, 230, 232, 233) von einer Zwischenverzögerungseinheit (220) in der Kette zur ersten Verzögerungseinheit (220) in der Kette, wobei die Zwischenverzögerungseinheit (220) zwischen der ersten Verzögerungseinheit (220) in der Kette und der letzten Verzögerungseinheit (220) in der Kette angeordnet ist,
**dadurch gekennzeichnet, dass** der erste Rückkopplungssignalpfad (226, 228, 230, 231, 233) und der zweite Rückkopplungssignalpfad (226, 228, 230, 232, 233) Folgendes umfassen:
einen ersten Rückkopplungszweig (231), der mit der letzten Verzögerungseinheit (220) in der Kette gekoppelt ist,
einen zweiten Rückkopplungszweig (232), der mit der Zwischenverzögerungseinheit (220) in der Kette gekoppelt ist,
einen gemeinsamen Rückkopplungszweig (226, 228, 230, 233), der einen Multiplexer (233) umfasst, der mit dem ersten Rückkopplungszweig (231) und mit dem zweiten Rückkopplungszweig (232) gekoppelt ist, wobei der Multiplexer (233) so konfiguriert ist, dass er der ersten Verzögerungseinheit (220) in der Kette ein Rückkopplungssignal (feed_sig) liefert, das abwechselnd auf Folgendem basiert:
einer ersten Rückkopplungssignalkomponente (clk_set), die von der letzten Verzögerungseinheit (220) in der Kette über den ersten Rückkopplungsszweig (231) empfangen wird, oder
einer zweiten Rückkopplungssignalkomponente (clk_clr), die von der Zwischenverzögerungseinheit (220) in der Kette über den zweiten Rückkopplungszweig (232) empfangen wird.

2. Schaltung (10) nach Anspruch 1, wobei die Zwischenverzögerungseinheit (220) in der Kette mindestens etwa zur Hälfte zwischen der ersten Verzögerungseinheit (220) in der Kette und der letzten Verzögerungseinheit (220) in der Kette angeordnet ist.

3. Schaltung (10) nach Anspruch 2, umfassend eine kaskadierte Anordnung von N Verzögerungseinheiten (220) in der Kette, wobei die Zwischenverzögerungseinheit (220) an einer Position in der Kette angeordnet ist, die von der ersten Verzögerungseinheit (220) gezählt wird, die eine nächstgelegene Ganzzahl von N/2 ist.

4. Schaltung (10) nach einem der vorhergehenden Ansprüche, wobei die Rückkopplungsschaltung (226, 228, 230, 231, 232, 233) eine Inversionslogik im ersten Rückkopplungssignalpfad (231) und im zweiten Rückkopplungssignalpfad (232) umfasst.

5. Schaltung (10) nach Anspruch 1, wobei:
der erste Rückkopplungszweig ein erstes UND-Gate (231) umfasst, das als ersten Eingang und als zweiten, negativen Eingang das Eingangssignal (DIN) empfängt, das an den Eingang und an den Ausgang der letzten Verzögerungseinheit (220) in der Kette weitergeleitet wird,
der zweite Rückkopplungszweig ein zweites UND-Gate (231) umfasst, das als ersten Eingang und als zweiten, negativen Eingang das Eingangssignal (DIN) empfängt, das an den Eingang und an den Ausgang der Zwischenverzögerungseinheit (220) in der Kette weitergeleitet wird.

6. Schaltung (10) nach Anspruch 1 oder Anspruch 5, wobei der gemeinsame Rückkopplungszweig (228, 230, 233) ein vom Multiplexer (233) angetriebenes Flip-Flop (230) umfasst, das so konfiguriert ist, dass es das Rückkopplungssignal (feed_sig) als Reaktion darauf erzeugt, dass es abwechselnd von der ersten von der letzten Verzögerungseinheit (220) in der Kette über den ersten Rückkopplungszweig (231) empfangenen Rückkopplungssignalkomponente (clk_clr) und von der Zwischenverzögerungseinheit (220) in der Kette über den zweiten Rückkopplungszweig (232) empfangenen Rückkopplungssignalkomponente (clk_set) getaktet wird.

7. Schaltung (10) nach Anspruch 6, wobei das Flip-Flop (230) nach einer logischen Inversion (234) das Rückkopplungssignal (feed_sig) als Eingang empfängt.

8. Schaltung (10) nach einem der vorhergehenden Ansprüche, wobei die Rückkopplungsschaltkreise (226, 228, 230, 231, 232, 233) ein Freigabe-Gate (228) umfassen, das so konfiguriert ist, dass es die Weiterleitung des Rückkopplungssignals (feed_sig) an die erste Verzögerungseinheit (220) in der Kette basierend auf einem Freigabesignal (EN) erleichtert bzw. verhindert.

9. Schaltung (10) nach einem der vorhergehenden Ansprüche, umfassend ein Eingangs-Gate (266), das so konfiguriert ist, dass es das Eingangssignal (DIN) erzeugt, das entlang der Verzögerungseinheiten (220) in der Kette als logische Summe des Rückkopplungssignals (feed_sig) mit einem gepulsten Startsignal (PulseIN/Start) weitergeleitet wird, wobei das gepulste Startsignal (PulseIN/Start) vorzugsweise eine Dauer aufweist, die ein Vielfaches der Ein- bis Ausgangsverzögerungszeit (Td) der Verzögerungseinheiten in der kaskadierten Anordnung der Verzögerungseinheiten (220) ist.

10. Schaltung (10) nach einem der vorhergehenden Ansprüche, wobei der Logikschaltkreis Folgendes umfasst:
einen Satz von UND-Gates (222), die mit abwechselnden der Verzögerungseinheiten (220) in der Kette gekoppelt sind, wobei jedes UND-Gate im Satz einen ersten Eingang, der mit dem Eingang (DIN, DLL1, DLL3, DLL5) einer jeweiligen Verzögerungseinheit (220) gekoppelt ist, und einen zweiten Eingang aufweist, der mit dem invertierten Eingang (DLL0, DLL2, DLL4, DLL6) der Verzögerungseinheit nach der jeweiligen Verzögerungseinheit (220) in der Kette gekoppelt ist, und
ein ODER-Gate (224), das mit den Ausgängen des UND-Gates in dem Satz von UND-Gates (222) gekoppelt ist, wobei das ODER-Gate (224) das Taktsignal (CLK) erzeugt.

11. Vorrichtung, die Folgendes umfasst:
eine Schaltung (10) nach einem der vorhergehenden Ansprüche, und
eine Benutzervorrichtung (UD), die mit der Logikschaltung (222, 224) in der Schaltung gekoppelt ist, um von ihr das Taktsignal (CLK) zu empfangen.

12. Verfahren, umfassend:
Anordnen einer Vielzahl von Verzögerungseinheiten (220) in einer Kette kaskadierter Einheiten, die jeweils eine Eingangs-zu-Ausgangs-Verzögerungszeit (Td) aufweisen und der ersten Verzögerungseinheit (220) in der Kette ein Eingangssignal (DIN) liefern, das entlang der Verzögerungseinheiten (220) in der Kette weitergeleitet wird,
Erzeugen eines Taktsignals (CLK) als logische Kombination von Signalen, die in die Verzögerungseinheiten (220) in der Kette eingegeben und von diesen ausgegeben werden, und Weiterleiten eines Rückkopplungssignals (feed_sig) an die erste Verzögerungseinheit (220) in der Kette über:
einen ersten Rückkopplungssignalpfad (226, 228, 230, 231, 233) von der letzten Verzögerungseinheit (220) in der Kette zur ersten Verzögerungseinheit (220) in der Kette, und
einen zweiten Rückkopplungssignalpfad (226, 228, 230, 232, 233) von einer Zwischenverzögerungseinheit (220) in der Kette zur ersten Verzögerungseinheit (220) in der Kette, wobei die Zwischenverzögerungseinheit (220) zwischen der ersten Verzögerungseinheit (220) in der Kette und der letzten Verzögerungseinheit (220) in der Kette angeordnet ist,
**dadurch gekennzeichnet, dass** der erste Rückkopplungssignalpfad (226, 228, 230, 231, 233) und der zweite Rückkopplungssignalpfad (226, 228, 230, 232, 233) Folgendes umfassen:
einen ersten Rückkopplungszweig (231), der mit der letzten Verzögerungseinheit (220) in der Kette gekoppelt ist,
einen zweiten Rückkopplungszweig (232), der mit der Zwischenverzögerungseinheit (220) in der Kette gekoppelt ist,
einen gemeinsamen Rückkopplungszweig (226, 228, 230, 233), der einen Multiplexer (233) umfasst, der mit dem ersten Rückkopplungszweig (231) und mit dem zweiten Rückkopplungszweig (232) gekoppelt ist, wobei der Multiplexer (233) so konfiguriert ist, dass er der ersten Verzögerungseinheit (220) in der Kette ein Rückkopplungssignal (feed_sig) liefert, das abwechselnd auf Folgendem basiert:
einer ersten Rückkopplungssignalkomponente (clk_set), die von der letzten Verzögerungseinheit (220) in der Kette über den ersten Rückkopplungsszweig (231) empfangen wird, oder
einer zweiten Rückkopplungssignalkomponente (clk_clr), die von der Zwischenverzögerungseinheit (220) in der Kette über den zweiten Rückkopplungszweig (232) empfangen wird.

## Revendications

1. Circuit (10), comprenant :
un agencement en cascade d'unités de retard (220) dans une chaîne, chaque unité de retard (220) ayant un temps de retard entrée-vers-sortie (Td), dans lequel la première unité de retard (220) dans la chaîne est configurée pour recevoir un signal d'entrée (DIN) qui est propagé le long des unités de retard (220) dans la chaîne,
un circuit logique (222, 224) couplé aux unités de retard (220) dans la chaîne, le circuit logique (222, 224) configuré pour générer un signal d'horloge (CLK) comme une combinaison logique de signaux entrés dans et sortis des unités de retard (220) dans la chaîne, et
un circuit de rétroaction (226, 228, 230, 231, 232, 233) configuré pour fournir à la première unité de retard (220) dans la chaîne un signal de rétroaction (feed_sig), le circuit de rétroaction (228, 230, 231, 232, 233) comprenant :
un premier chemin de signal de rétroaction (226, 228, 230, 231, 233) depuis la dernière unité de retard (220) dans la chaîne vers la première unité de retard (220) dans la chaîne, et
un second chemin de signal de rétroaction (226, 228, 230, 232, 233) depuis une unité de retard (220) intermédiaire dans la chaîne vers la première unité de retard (220) dans la chaîne, l'unité de retard (220) intermédiaire dans la chaîne étant agencée entre la première unité de retard (220) dans la chaîne et la dernière unité de retard (220) dans la chaîne,
**caractérisé en ce que** le premier chemin de signal de rétroaction (226, 228, 230, 231, 233) et le second chemin de signal de rétroaction (226, 228, 230, 232, 233) comprennent :
une première branche de rétroaction (231) couplée à la dernière unité de retard (220) dans la chaîne,
une seconde branche de rétroaction (232) couplée à l'unité de retard (220) intermédiaire dans la chaîne,
une branche de rétroaction commune (226, 228, 230, 233) comprenant un multiplexeur (233) couplé à la première branche de rétroaction (231) et à la seconde branche de rétroaction (232), le multiplexeur (233) configuré pour fournir à la première unité de retard (220) dans la chaîne un signal de rétroaction (feed_sig) en se basant sur, alternativement :
une première composante de signal de rétroaction (clk_set) reçue depuis la dernière unité de retard (220) dans la chaîne via la première branche de rétroaction (231), ou
une seconde composante de signal de rétroaction (clk_clr) reçue depuis l'unité de retard (220) intermédiaire dans la chaîne via la seconde branche de rétroaction (232).

2. Circuit (10) selon la revendication 1, dans lequel l'unité de retard (220) intermédiaire dans la chaîne est agencée au moins approximativement à mi-chemin entre la première unité de retard (220) et la dernière unité de retard (220) dans la chaîne.

3. Circuit (10) selon la revendication 2, comprenant un agencement en cascade de N unités de retard (220) dans ladite chaîne, dans lequel ladite unité de retard (220) intermédiaire est agencée dans une position dans la chaîne comptée depuis la première unité de retard (220) qui est un entier le plus proche de N/2.

4. Circuit (10) selon l'une quelconque des revendications précédentes, dans lequel le circuit de rétroaction (226, 228, 230, 231, 232, 233) inclut une logique d'inversion dans le premier chemin de signal de rétroaction (231) et dans le second chemin de signal de rétroaction (232).

5. Circuit (10) selon la revendication 1, dans lequel :
la première branche de rétroaction comprend une première porte ET (231) recevant comme une première entrée et comme une seconde entrée inversée ledit signal d'entrée (DIN) propagé vers l'entrée et vers la sortie de la dernière unité de retard (220) dans la chaîne,
la seconde branche de rétroaction comprend une seconde porte ET (231) recevant comme une première entrée et comme une seconde entrée inversée ledit signal d'entrée (DIN) propagé vers l'entrée et vers la sortie de l'unité de retard (220) intermédiaire dans la chaîne.

6. Circuit (10) selon la revendication 1 ou la revendication 5, dans lequel la branche de rétroaction commune (228, 230, 233) comprend une bascule (230) commandée par le multiplexeur (233) et configurée pour produire ledit signal de rétroaction (feed_sig) en réponse à sa synchronisation, alternativement, par la première composante de signal de rétroaction (clk_set) reçue depuis la dernière unité de retard (220) dans la chaîne via la première branche de rétroaction (231) et par la seconde composante de signal de rétroaction (clk_clr) reçue depuis l'unité de retard (220) intermédiaire dans la chaîne via la seconde branche de rétroaction (232).

7. Circuit (10) selon la revendication 6, dans lequel la bascule (230) reçoit comme entrée ledit signal de rétroaction (feed_sig) après inversion logique (234).

8. Circuit (10) selon l'une quelconque des revendications précédentes, dans lequel le circuit de rétroaction (226, 228, 230, 231, 232, 233) comprend une porte d'activation (228) configurée pour faciliter et contrer, respectivement, l'envoi du signal de rétroaction (feed_sig) vers la première unité de retard (220) dans la chaîne en se basant sur un signal d'activation (EN).

9. Circuit (10) selon l'une quelconque des revendications précédentes, comprenant une porte d'entrée (266) configurée pour produire le signal d'entrée (DIN) propagé le long des unités de retard (220) dans la chaîne comme la somme logique dudit signal de rétroaction (feed_sig) avec un signal de démarrage pulsé (PulseIN/Start), le signal de démarrage pulsé (PulseIN/Start) ayant de préférence une durée qui est un multiple du temps de retard entrée-vers-sortie (Td) des unités de retard dans ledit agencement en cascade des unités de retard (220).

10. Circuit (10) selon l'une quelconque des revendications précédentes, dans lequel le circuit logique comprend :
un ensemble de portes ET (222) couplées à des unités de retard (220) alternées dans ladite chaîne, dans lequel chaque porte ET dans l'ensemble a une première entrée couplée à l'entrée (DIN, DLL1, DLL3, DLL5) d'une unité de retard (220) respective couplée à celle-ci et une seconde entrée couplée à l'entrée inversée (DLL0, DLL2, DLL4, DLL6) de l'unité de retard suivant l'unité de retard (220) respective dans la chaîne, et
une porte OU (224) couplée aux sorties des portes ET (222) dans ledit un ensemble de portes ET (222), la porte OU (224) produisant ledit signal d'horloge (CLK).

11. Dispositif, comprenant :
un circuit (10) selon l'une quelconque des revendications précédentes, et
un dispositif utilisateur (UD) couplé audit circuit logique (222, 224) dans le circuit pour recevoir ledit signal d'horloge (CLK) depuis celui-ci.

12. Procédé, comprenant :
d'agencer dans une chaîne d'unités en cascade une pluralité d'unités de retard (220) ayant chacune un temps de retard entrée-vers-sortie (Td), et de fournir à la première unité de retard (220) dans la chaîne un signal d'entrée (DIN) qui est propagé le long des unités de retard (220) dans la chaîne,
de générer un signal d'horloge (CLK) comme une combinaison logique de signaux entrés dans et sortis des unités de retard (220) dans la chaîne, et
d'envoyer vers la première unité de retard (220) dans la chaîne un signal de rétroaction (feed_sig) via :
un premier chemin de signal de rétroaction (226, 228, 230, 231, 233) depuis la dernière unité de retard (220) dans la chaîne vers la première unité de retard (220) dans la chaîne, et
un second chemin de signal de rétroaction (226, 228, 230, 232, 233) depuis une unité de retard (220) intermédiaire dans la chaîne vers la première unité de retard (220) dans la chaîne, l'unité de retard (220) intermédiaire dans la chaîne étant agencée entre la première unité de retard (220) dans la chaîne et la dernière unité de retard (220) dans la chaîne,
**caractérisé en ce que** le premier chemin de signal de rétroaction (226, 228, 230, 231, 233) et le second chemin de signal de rétroaction (226, 228, 230, 232, 233) comprennent :
une première branche de rétroaction (231) couplée à la dernière unité de retard (220) dans la chaîne,
une seconde branche de rétroaction (232) couplée à l'unité de retard (220) intermédiaire dans la chaîne,
une branche de rétroaction commune (226, 228, 230, 233) comprenant un multiplexeur (233) couplé à la première branche de rétroaction (231) et à la seconde branche de rétroaction (232), le multiplexeur (233) configuré pour fournir à la première unité de retard (220) dans la chaîne un signal de rétroaction (feed_sig) en se basant sur, alternativement :
une première composante de signal de rétroaction (clk_set) reçue depuis la dernière unité de retard (220) dans la chaîne via la première branche de rétroaction (231), ou
une seconde composante de signal de rétroaction (clk_clr) reçue depuis l'unité de retard (220) intermédiaire dans la chaîne via la seconde branche de rétroaction (232).
